# EUROPEAN PATENT APPLICATION

(11) **EP 0 831 402 A1**
(43) Date of publication of application: **25.03.1998**
(21) Application number: 97104315.3
(22) Date of filing: 13.03.1997
(51) Int. Cl.: G06F 12/06, G11C 8/00

(54) **Dynamically configuring timing to match memory bus loading conditions**

(30) Priority: 23.09.1996 US 717983
(71) Applicant: Hewlett-Packard Company, Palo Alto, California 94304 (US)
(72) Inventor: Pew, Frederick W., Boise, Idaho 83709 (US); Juve, Ronald A., Washington 98606 (US); Skurdal, Vincent C., Boise, Idaho 93709 (US)
(74) Representative: Schoppe, Fritz, Dipl.-Ing.

(57) **Abstract**

Given a large number of memory banks (101-103) in an expandable memory system, the amount of capacitive loading on the memory bus (40, 38) may be excessive. If the memory controller (14) is designed to operation with a heavily loaded memory bus, the system is non-optimum for a lightly loaded system. The present invention dynamically inserts a one-half clock delay (503,506) if the memory bus (40,38) loading is determined to be heavily loaded. By delaying both RAS and CAS by one-half of a clock cycle, there is no need to degrade the system performance when the system is lightly loaded.

## Description

### Technical Field

The present invention relates generally to the field of computer memory and more particularly, to changing memory access timing in accordance with loading conditions on the memory bus.

### Background of the Invention

A typical computer system consists of a number of modules or components. Computer systems typically include a central processing unit (CPU) such as a microprocessor. The microprocessor is a program-controlled device that obtains, decodes and executes instructions. A computer system also includes program storage components for storing program instructions, and data storage components for storing data. These storage components may be read only memory (ROM), random access memory (RAM), disk or tape storage, or any other suitable storage means.

A computer system typically also includes input/output (I/O) components for connecting external devices to the microprocessor. Special purpose components, such as memory management units or co-processors, may also be part of the computer system.

The memory component, also known as a "main memory," is a scarce resource that is dynamically allocated. Main memory is typically a silicon-based memory such as a RAM. In many applications, dynamic random access memory (DRAM) is used as the main memory.

DRAMs are implemented in a way that exposes their internal structure, which is typically a near-square array of bits. A particular bit is specified by its row and column in the array. In the 1970s, as DRAMs grew in capacity, the cost of a package with all the necessary address lines became an issue. The solution was to multiplex the address lines, thereby cutting the number of address pins in half. The top half of the address comes first, during the "row-access strobe", or RAS. This operation is followed by the second half of the address during the "column-access strobe", or CAS. These names come from the internal chip organization, for memory is organized as a rectangular matrix addressed by rows and columns.

An additional requirement of DRAMs derives from the property signified by its first letter D for "dynamic." A "refresh" operation is required with DRAMs in order to maintain the information stored at each memory location due to the circuitry used. Refresh is done periodically by writing back data after it is read. Because of this refresh operation, every DRAM must have every row accessed within a certain time window, such as 2 milliseconds, or the information in the DRAM may be lost. This requirement means that the memory system is occasionally unavailable because it is sending a signal telling every chip to refresh. The time cost of a refresh is typically a full memory access (RAS and CAS) for each row of the DRAM. Since the memory matrix in a DRAM is likely to be square, the number of steps in a refresh is usually the square root of the DRAM capacity. The cycle time for DRAMs is therefore the access time plus the refresh time.

DRAM access times are divided into row access and column access. During each row access a DRAM will usually store one or more column bit locations in that row. This row is usually the square root of the DRAM size (e.g., 1024 bits for 1 Mbit, 2048 for 4 Mbits, and so on). DRAMs also come with optional timing signals that allow repeated column accesses to the memory after a single row-access time. These timing signals allow for information to be read out of a DRAM in one of several optimal ways that can optimize data retrieval.

There are three data retrieval optimization modes: nibble mode, page mode and static column mode. In "nibble mode", the DRAM can supply three extra bits from sequential locations for every row access. Contrastingly, by changing column address in "page mode", multiple random bits can be accessed in the buffer until the next row access or refresh time. "Static column mode" is very similar to page mode, except that it is not necessary to hit the column-access strobe line every time the column address changes. The static column mode has been given the acronym SCRAM, for static column DRAM.

Starting with conventional 1-Mbit DRAMS, most chips can perform any of the three modes. The desired optimization mode is selected at the time the chip is packaged by choosing which pads to wire-up as specified by the manufacturer. These modes change the definition of cycle time for DRAMS.

The advantage of these optimization modes is that they use the circuitry already on the DRAMS, adding little cost to the system while achieving almost a fourfold improvement in bandwidth. For example, nibble mode was designed to take advantage of the same program behavior as interleaved memory. The chip reads four bits at a time internally, supplying four bits externally in the time of four optimized cycles. Unless the bus transfer time is faster than the optimized cycle time, the cost of four-way interleaved memory is only more complicated timing control. Page mode and static column mode are also used to get even higher interleaving with slightly more complex control.

Thus, it is expected that most main memory systems in the future will use such optimization techniques to reduce the CPU-DRAM performance gap. Unlike traditional interleaved memories, there are no disadvantages using these DRAM modes as DRAMs scale upward in capacity, nor is there the problem of the minimum expansion increment in main memory.

Presently, main memory is expanded by adding DRAMs mounted on "single in-line memory modules" (SIMM). SIMMs are available off-the-shelf for most personal computers, workstations, and the like. Typically, these systems have main memory requirements in the range of 1-32 Mbytes. However, shared main memory multiprocessing systems have much greater main memory requirements.

Each additional SIMM adds additional capacitive loading on the memory address and data buses. For large memory configurations, the multiplexed address (MA) bus may require additional settling time before the address is valid. Buffering the MA (bMA) signal, which may be required for large memory configurations, adds more delay associated with the buffer. Typically, the access time of the memory is chosen so that it can operate at the system's selected clock speed. Timing of the control signal is chosen for reliable operation under worst case operating and loading conditions. However, worst case loading may only exist in a small number of systems.

Prior to the present invention, several techniques were used to overcome problems with user configurable memory systems. The simplest technique is to design the system using the worst case loading assumption for all configurations. This simple approach forces degradation of overall system performance for those systems that have small memory configurations. Yet another approach requires the user configure the system based on the type and amount of memory installed. Any requirement for user configuration is error prone and may render the system in operable is an illegal configuration is selected.

### Summary of the Invention

In order to accomplish the present invention there is provided an apparatus for accessing memory. The apparatus is constructed from a memory module that is plugged into a memory module socket. A memory loading indicator is connected to the memory module socket. The memory loading indicator reads an identifier from the plugged-in memory module. From the identity information, a memory controller can determine how many memory modules are present and of what type they are. The memory controller inserts additional time during an access to the memory module if the memory loading indicator indicates that the bus is loaded beyond a set amount.

### Brief Description of the Drawings

A better understanding of the invention may be had from the consideration of the following detailed description taken in conjunction with the accompanying drawings in which:
FIG. 1 is a high level block diagram in accordance with the present invention.
FIG. 2 illustrates a representative timing diagram showing valid timing relationship.
FIG. 3 illustrates a representative timing diagram showing invalid timing relationship.
FIG. 4 illustrates a representative timing diagram showing valid timing relationship as corrected in accordance with the present invention
FIG. 5 is a simplified state diagram for a memory operation in accordance with the present invention.

### Detailed Description Of The Preferred Embodiments

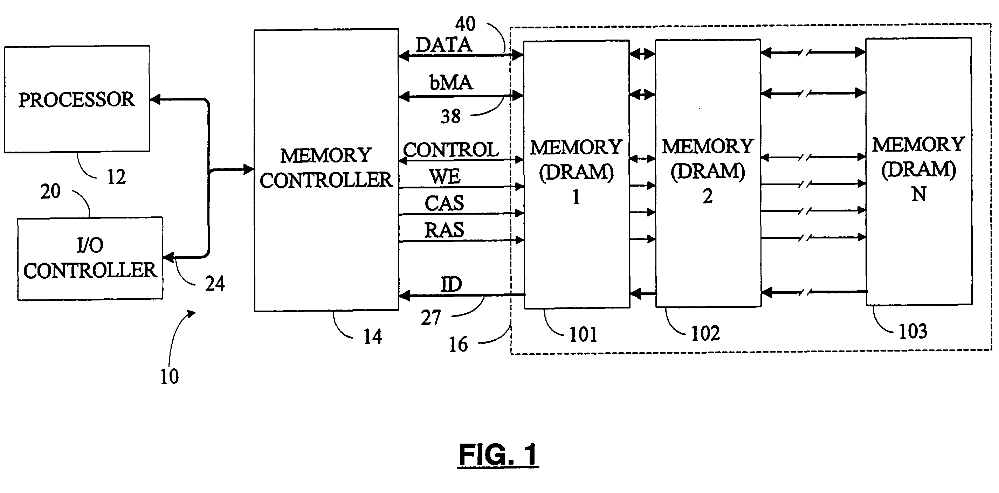

The present invention is not limited to a specific embodiment illustrated herein. A block diagram of a computer system incorporating the present invention is shown in FIG. 1. A computer system 10 includes a central processing unit (CPU) such as a microprocessor 12. A memory subsystem includes a memory controller 14 and a memory 16. The memory controller 14 controls access by microprocessor 12 to memory 16. The computer system 10 further includes an input output (I/O) controller 20 which controls communication with I/O devices (not shown). The microprocessor 12, the memory controller 14 and the I/O controller 20 are connected to and communicate on a bus 24.

The memory controller 14 is typically a large scale integrated circuit which receives an address from microprocessor 12 on bus 24 and provides control signals to memory 16 for reading or writing to a specified location in memory 16. As described below, the memory 16 provides presence detect bits to memory controller 14 over ID bus 27.

An address bus 38 (bMA) carries addresses from the memory controller 14 to the memory 16, and a data bus 40 carries data between memory 16 and memory controller 14. The memory controller 14 provides control signals to the memory 16. In particular, column address strobe (CAS) signals and row address strobe (RAS) signals are generated by memory controller 14. The RAS signal is used to strobe row addresses into the DRAM chips of memory 16. Similarly, the CAS signal is used to strobe column addresses into the dynamic random access memory (DRAM) chips of memory 16. Before a location in memory 16 can be accessed, its row address and column address must be strobed into the DRAM chips using the RAS and CAS signals. A write enable (WE) signal is provided by the memory controller 14 to enable data to be written to the DRAM chips of memory 16.

Memory 16 includes slots, or connectors, in which memory modules can be installed. Each slot may hold a single memory module. The user of the computer system 10 configures the system as required for a particular application by installing memory modules in the slots. Each slot can be loaded with an industry standard single in-line memory module (SIMM).

Each SIMM may include up to 18 DRAM chips which may be 1 MBit chips, 4 MBit chips or 16 MBit chips. All the DRAM chips on a single SIMM are of the same memory capacity with the potential exception of the parity bit.

Each SIMM outputs identity (ID) bits 27 that are utilized as described below to determine a memory configuration. Each of the memory modules, or SIMMs, in the memory 16 produces 4 presence detect bits. The 4 bits from each SIMM are encoded to indicate the memory module size and the speed of the DRAM chips.

Still referring to FIG. 1, in the preferred embodiment, every system includes the first memory module 101. Additional memory modules 102-103 can be added. Each memory module places additional loading on the signals from memory controller 14. Of the several signals between memory controller 14 and memory 16, the bMA bus 38 is most sensitive to the additional loading. Thus, as additional memory modules are added, the bMA bus 38 needs additional settling time.

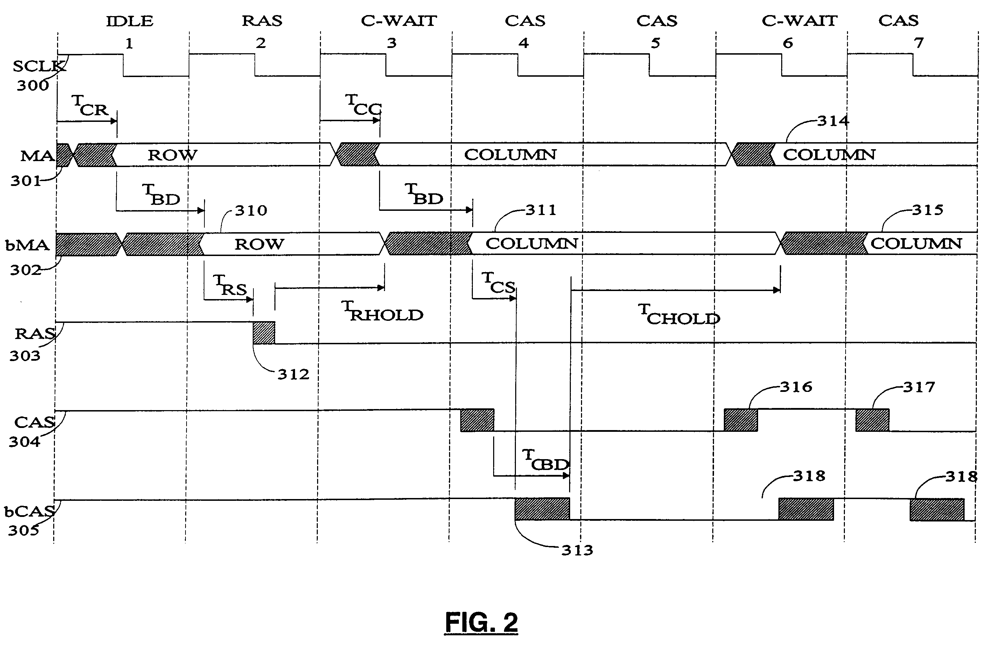

The timing diagram of FIG. 2 shows the normal timing under light loading conditions according to the present invention. FIG. 2 includes the six following signal traces: System Clock (SCLK) 300, Multiplexed Address (MA) 301, buffered Multiplexed Address (bMA) 302, RAS 303, CAS 304, and buffered CAS (bCAS) 305. With the exception of MA 301 and CAS 302, the timing parameters shown in FIG. 2 generally represent time periods as measured at the SIMM connector, ignoring any small effect the connector itself may have on the signals. These times would appear different if measured at a different location.

The row and column addresses are sent by the memory controller 14 to the memory 16 according to bMA 302. The MA signal 301 is internal to memory controller, but shown here to aid the reader in understanding the present invention. For example, processor 12 accesses memory 16 by placing an address and the proper control signals on bus 24. Memory controller 14 translates the processor request into the proper format for memory 16. During state 1 (IDLE) of FIG. 2, memory controller 14 generates the internal multiplexed address MA 301. The MA bus is valid after T_{CR} time. The MA bus 301 passes through buffers to generate bMA 302. In FIG. 2, a buffer adds a delay of T_{BD}.

The row address is first applied by the memory controller 14 as shown at time 310. Next, after RAS setup time (T_{RS}), RAS is asserted at time 312. In the preferred embodiment, RAS 303 changes on the falling edge of SCLK during state 2 (RAS). Address bus bMA 302 must not change until RAS hold time (T_{RHOLD}) after RAS has settled.

The rising edge of SCLK 300 during state 3 (C-Wait) causes memory controller 14 to change MA from outputting the row to outputting the column. The MA bus 301 generates a valid column after T_{CC} time. As with the row output, the bMA bus 302 outputs a valid column 311 after T_{BD} time. The rising edge of SCLK 300 during state 4 (CAS) causes memory controller 14 to generate CAS 304. After T_{CBD} time, the buffered CAS 305 is valid 313. As specified for the SIMM memory, bCAS 305 can not be asserted until T_{CS} after bMA 302 is valid and bMA 302 must continue to output column T_{CHOLD} after bCAS 305 is valid.

If the next memory access is to a subsequent memory location, the memory controller 14 can simply assert a new column, leaving the row address unchanged. Still referring to FIG. 2, during state 6 (C-WAIT) MA 301 changes to a new column output. After the buffer delay of T_{BD}, bMA 302 outputs the new column address 312. The rising edge of SCLK 300 also forces CAS 304 to toggle high 316. After T_{CBD}, bCAS goes high 318. During sate 7 (CAS) CAS 304 is asserted 317, which causes bCAS to be asserted 318. One skilled in the art will understand that states 6 and 7 are actually states 3 and 4 repeated. To complete the second memory access, a state 5 (CAS) would follow state 7. Memory 16 can continue to be accessed this way by repeatedly cycling through states 3 through 5.

Summarizing FIG. 2, during a normal memory access, bMA 302 must be valid T_{RS} time before asserting RAS 303 and bMA 302 must continue to output ROW T_{RHOLD} time after RAS 303 is valid. Also, bMA 302 must be valid T_{CS} before bCAS 305 is asserted and continue to output COLUMN for T_{CHOLD} time after bCAS 305 is valid. One skilled in the art will understand that there are several other critical timing requirement not shown in FIG. 2 anyone of which, if not met, may cause problems accessing the memory. Table 1 shows exemplary times for the times shown in FIG 2.

**TABLE 1**

| Parameter | MIN | MAX |
|---|---|---|
| T_{CR} | 1 ns | 5 ns |
| T_{CC} | 6 ns | 15 ns |
| T_{BD} | 5 ns | 15 ns |
| T_{RS} | 0 ns | |
| T_{RHOLD} | 10 ns | |
| T_{CS} | 0 ns | |
| T_{CHOLD} | 15 ns | |
| T_{CBD} | 3 ns | 10 ns |

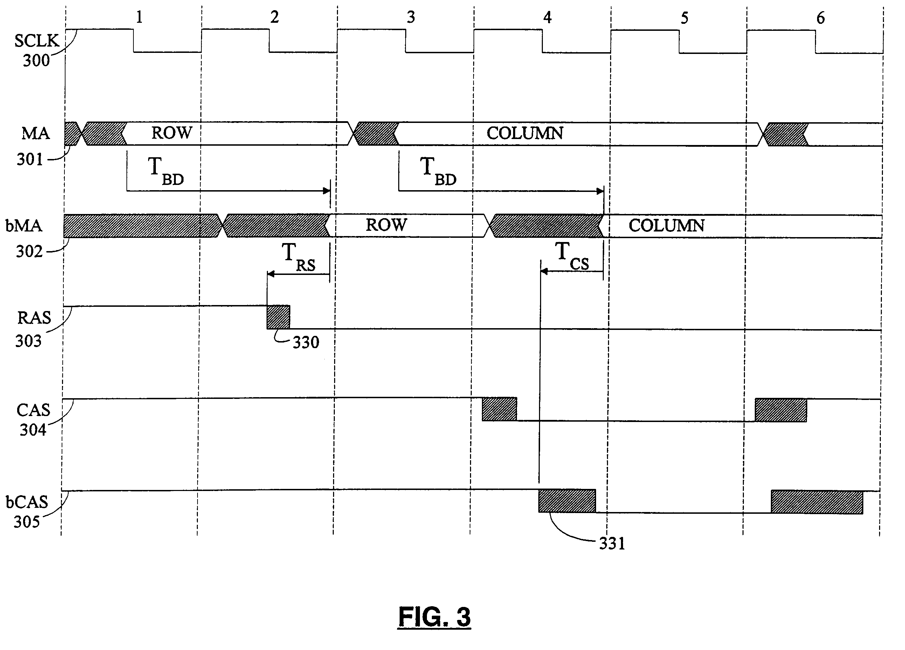

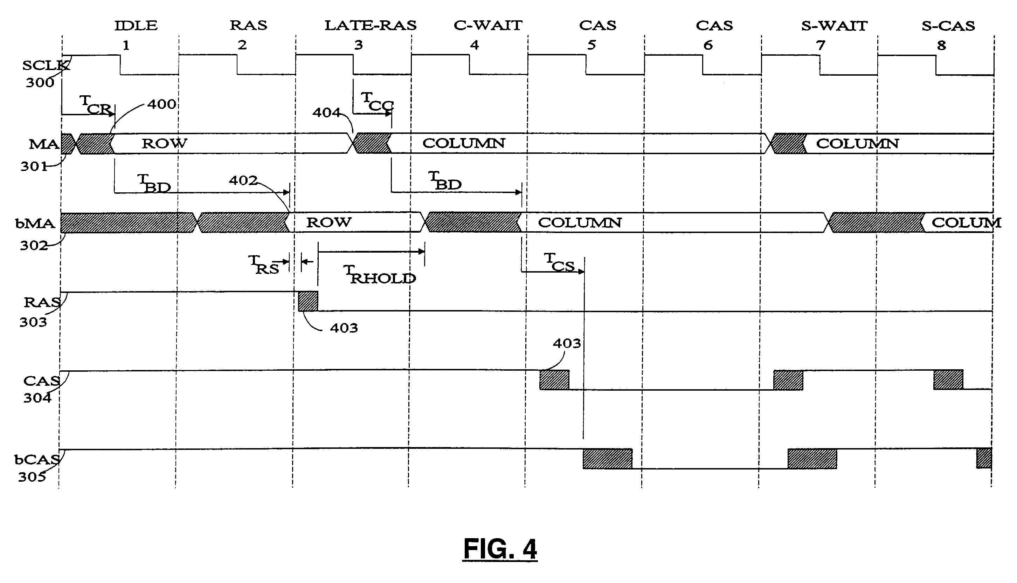

As more SIMMs are added to memory 16, bMA 302 needs additional time to settle. Eventually, the T_{RS} or T_{CS} times are not met, thereby causing timing errors during memory accesses. The timing diagram of FIG. 3 is exemplary of a fully loaded system. Note that the T_{BD} delay of FIG. 3 is much longer than in FIG. 2. FIG. 3 uses the same timing for RAS 303 and CAS 304 as in FIG. 2. Here, however, both T_{RS} 330, which is the row setup, and T_{CS} 331, which is the column setup, are not meet. This memory system will not function properly. By delaying both RAS and CAS by one-half of a clock cycle, as shown in FIG. 4, both T_{RS} and T_{CS} are met.

Examining FIG. 4 in detail, note that bMA 302 settles 402 much later than in FIG. 2. The T_{RS} time is met by delaying RAS 303 one-half clock cycle, such that it changes on the rising edge of state 3 (LATE-RAS). Next, on the falling edge of state 3 (LATE-RAS) MA 301 changes at time 404 to output the column. During state 4 (C-WAIT) bMA 302 is allowed to settle before CAS 304 is asserted 405 during state 5 CAS. Sometime during state 5, bCAS 305 settles thereby strobing the column on bMA 302 into the memory. Subsequent memory accesses are accomplished by first entering state 7 (S-WAIT) where MA 301 is changes to the new column. Also, the rising edge during state 7 forces CAS 304 to go high. The falling edge of SCLK 300 during state 8 (S-CAS) toggles CAS back to low. As before, sometime during state 8, bCAS 305 settles thereby strobing the column on bMA 302 into the memory. After state 8, state 6 in entered and the process can be repeated for subsequent accesses. Additional time, in the form of "wait states" may be needed depending on the speed of the memory. Wait states are added by adding additional CAS states.

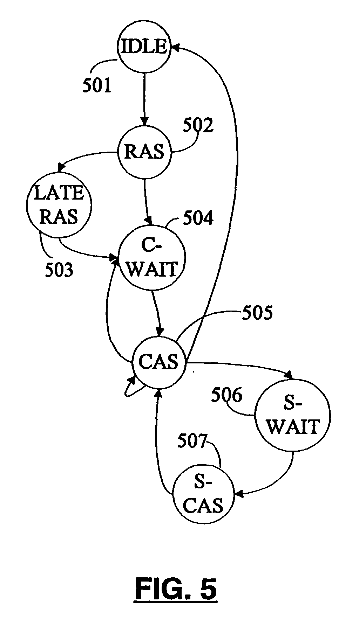

The timing diagrams of FIGs. 2 and 4 can be graphically represented by a state diagram. Referring now to the state diagram of FIG. 5, once a memory access is initiated, memory controller 14 leaves the IDLE state 501 and moves to the RAS state 502. Here, if the system is lightly loaded memory controller 14 asserts RAS as in FIG. 2. If the system is heavily loaded memory controller 14 proceeds directly to the LATE RAS state 503. In the LATE RAS state 503, the RAS signal is delayed by one-half clock as shown in FIG. 4. Independent of which route is taken, the next state is C-WAIT (Column Wait) 504. Here, if the system is lightly loaded, memory controller 14 changes to output the column address. For a heavily loaded system, the C-WAIT state allow sufficient time for bMA 302 to settle. Next, when memory controller 14 enters state CAS 505 the CAS signal 304 is asserted. Additional CAS states 505 may be added for each wait-state. If no additional memory requests are to be performed, the end of the memory operation is signaled by returning to the IDLE state 501. However, subsequent CAS requests can occur during a single RAS. For a lightly loaded system, subsequent accesses are accomplished by leaving CAS 505 and entering C-WAIT 504 and continuing as described above. A heavily loaded system needs additional settling time even on subsequent accesses. This is accomplished by entering the S-WAIT state 506. Here, memory controller 14 outputs the new column and removes CAS 304. During the next state S-CAS 507, memory controller 14 asserts CAS 304. Control continues then at CAS 505, where additional wait states may be needed as described above.

For the present invention to dynamically insert the one-half clock delay, the amount of anticipated memory bus loading must be known. Bus loading can be detected in several ways, for example, U.S. Patent No. 5,446,860 to Dresser et al. describes one such technique. In the preferred embodiment of the present invention, the industry standard SIMM identification is used. With this arrangement, each SIMM includes a four bit ID that is presented to the SIMM connector. The meaning of the four bits [3:0] are shown in TABLE 2. Thus, by reading the four bits associated with a given SIMM socket, the system can determine if a SIMM is present, along with additional information about the SIMM size and speed. The system then uses this information to decide if the extra one-half delay is necessary. Presently, the standard bus size is 32 bits. Thus, a single location can convey information about eight SIMMs.

**TABLE 2**

| Bits [3:2] | Speed (nS) | Bits [1:0] | Size (MB) | Banks Implied |
|---|---|---|---|---|
| 00 | 100 | 00 | 4 | 1 |
| 01 | 80 | 01 | 2 or 32 | 2 |
| 10 | 70 | 10 | 1 or 16 | 1 |
| 11 | No SIMM | 11 | 8 | 2 |

Although the preferred embodiment of the invention has been illustrated, and that form described, it is readily apparent to those skilled in the art that various modifications may be made therein without departing from the spirit of the invention or from the scope of the appended claims. For example, the above has been described as inserting a one-half delay. The selection of a single, one-half delay was chosen as a matter of design choice. A given system may require a different delay. Large, expandable memory systems may need additional delays. Thus, for example, a memory system with a single SIMM could use no delays. When the system has four SIMMs, a one-half delay could be added. If the system is expanded to use eight SIMMS, then a one cycle delay is used.

## Claims

1. An apparatus comprising:
a memory (16);
a processor (12);
a memory loading indicator (27) connected to said memory (16);
a bus (40,38) connected to said memory (16); and
a memory controller (14) connected to said processor (12), said memory loading indicator (27) and said bus (40,38), said memory controller (14) inserting additional time during an access to said memory (16) if said memory loading indicator (27) indicates that said bus (40,38) is loaded beyond a set amount.

2. The apparatus of claim 1 wherein said memory (16) further comprising:
at least one plug in module;
said at least one plug in module (101-103) further comprising an identity indicator; and
said identity indicator being connected to said memory loading indicator (27) when said at least one plug in module (101-103) is plugged in.

3. The apparatus of claim 1 wherein said bus further comprising:
a RAS signal (RAS);
a CAS signal (CAS);
a plurality of data signals (40); and
a plurality of control signals (control, 38).

4. The apparatus of claim 3, wherein:
said memory controller (14) inserting said additional time by adding time to said RAS signal (RAS) and adding time to said CAS signal (CAS).

5. An apparatus comprising:
at least one memory module (101-103);
at least one memory module socket (101), said at least one memory module (101-103) being inserted in said at least one memory module socket (101);
a processor (12);
a memory loading indicator (27) connected to said at least one memory module socket (101);
a bus (40,38) connected to said at least one memory module socket (101); and
a memory controller (14) connected to said processor (12), said memory loading indicator (27) and said bus (40,38), said memory controller (14) inserting additional time during an access to said at least one memory module (101-103) if said memory loading indicator (27) indicates that said bus (40,38) is loaded beyond a set amount.

6. The apparatus of claim 5 wherein said bus further comprising:
a RAS signal (RAS);
a CAS signal (CAS);
a plurality of data signals (40); and
a plurality of control signals (control, 38).

7. The apparatus of claim 6, wherein
said memory controller (14) inserting said additional time by adding time to said RAS signal (RAS) and adding time to said CAS signal (CAS).

8. The apparatus of claim 5 wherein said at least one memory module (101-105) further comprising:
an identity indicator (27); and
said identity indicator (27) being connected to said at least one memory module socket when said at least one memory module (101-105) is plugged into said at least one memory module socket (101).

9. A method for accessing memory (16), said method being performed by a memory controller (14), said method comprising the steps of:
detecting (27) an amount of loading created by said memory (16);
adjusting (504, 506) timing of signals (RAS,CAS) used to access said memory (16);
receiving a memory access request from a processor (12);
initiation (Fig. 2 - Fig. 4) a memory access;
inserting (503, 506) additional time if said step of detecting detects loading greater than set value; and
completing (505) said memory access.

10. The method of claim 9 wherein said step of detecting further comprising the step of reading an identity indicator from said memory (16).
